(19) Europäisches Patentamt
European Patent Office
Office européen des brevets

(11) EP 2 141 816 A1

(12) EUROPEAN PATENT APPLICATION

(43) Date of publication:
06.01.2010 Bulletin 2010/01

(51) Int Cl.:
*H03M 13/29* (2006.01)

(21) Application number: 09008577.0

(22) Date of filing: 30.06.2009

(84) Designated Contracting States:
AT BE BG CH CY CZ DE DK EE ES FI FR GB GR HR HU IE IS IT LI LT LU LV MC MK MT NL NO PL PT RO SE SI SK TR

(30) Priority: 03.07.2008 JP 2008175102

(71) Applicant: VICTOR COMPANY OF JAPAN, LIMITED
Yokohama-shi,
Kanagawa-ken, 221-8528 (JP)

(72) Inventors:
- Higurashi, Seiji
Yokohama-shi,
Kanagawa-ken, 221-8528 (JP)
- Nishitani, Masayoshi
Yokohama-shi,
Kanagawa-ken, 221-8528 (JP)
- Kuroiwa, Toshio
Yokohama-shi,
Kanagawa-ken, 221-8528 (JP)

(74) Representative: Wagner, Karl H.
Wagner & Geyer Partnerschaft
Patent- und Rechtsanwälte
Gewürzmühlstrasse 5
80538 München (DE)

# (54) Encoding method, encoding apparatus, decoding method, and decoding apparatus using block code

(57) The application relates to encoding and decoding of a code obtained from combining several codes with reduced overhead in terms of redundancy. An input sequence is sub-divided into a plurality of groups. For each group, a product-like code is generated. The checks-on-checks R generated from the vertical parity Q are appended to the data bits of the respective group. The plurality of groups and the associated parities R are then arranged in a two-dimensional array and parities S and T are generated by column-wise encoding in vertical direction. For decoding, the parities Q are regenerated and error correction is performed for each group on the basis of the regenerated parities Q and the respective parities R and for the ensemble of groups on the basis of the parities S and T.

FIG.5

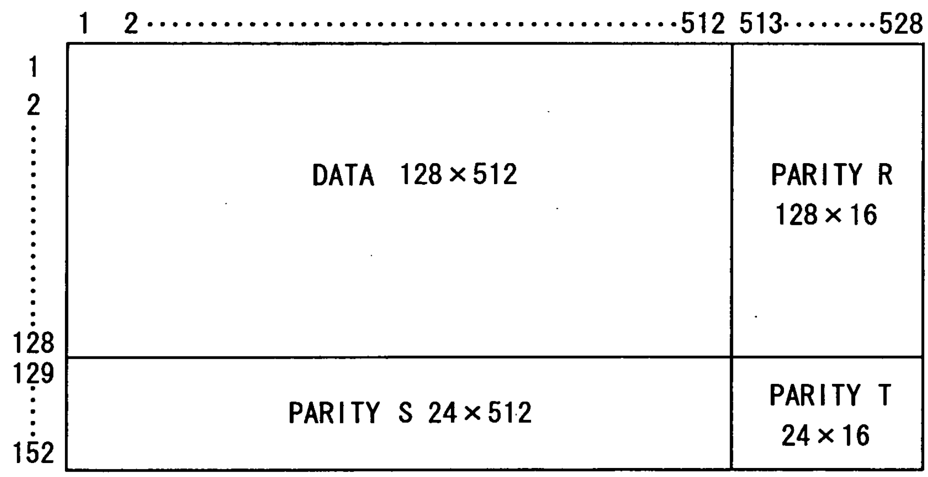


EP 2 141 816 A1

## Description

The present invention relates to an encoding technique and a decoding technique, and more particularly, to an encoding method, an encoding apparatus, a decoding method, and a decoding apparatus using a block code.

A product code obtained by two-dimensionally arranging block codes is used for an error correction technique for correcting an error of data. Block encoding is performed in the horizontal direction on each row of information codes that are two-dimensionally arranged in the product code to generate check symbols in the horizontal direction. In addition, block encoding is performed in the vertical direction on each column of the information codes and check symbols arranged in the horizontal direction to generate check symbols in the vertical direction. That is, in the product code, since the check symbols in the horizontal direction and the vertical direction are generated, it is possible to improve an error correction performance. For example, a Reed-Solomon code (hereinafter, referred to as an "RS" code) or a BCH (Bose-Chaudhuri-Hocquenghem) code is used as an example of the block code (for example, see Japanese Patent Application Laid-Open No. 2004-282600).

As described above, when a product code of the RS codes is used to for error correction, a parity P is generated as the check symbol in the horizontal direction, and a parity Q is generated as the check symbol in the vertical direction. In addition, a parity R, which is a check symbol in the horizontal direction for the parity Q and a check symbol in the vertical direction for the parity P, is also generated. In general, an 8-bit field is used as the Galois field of a code. In addition, since the length of a correction code is defined by the Galois field, a maximum code length is $255 \times 8$ bits. In this case, the size of data that can be simultaneously processed is $255 \times 255 \times 8$ bits, and it is difficult to simultaneously process data having a size that is larger than the above-mentioned value. As the size of the Galois field is increased, the size of data that can be simultaneously processed is increased. However, in this case, the amount of computation or a circuit size required for code correction is exponentially increased. Therefore, when data has a large size, the data is divided into a plurality of code sequences.

Further, as a pointer erasure method, a method using a CRCC error check function has been known which uses a CRC code in the horizontal direction instead of the RS code to generate a CRCC, instead of the parities P and R. However, in the pointer erasure method, even when an error of several bits occurs in one row in the horizontal direction, all the bits included in the row are considered as errors, and the errors are corrected, which results in a reduction in the efficiency of error correction. For example, when data having a size of 64 kbytes ($64 \times 1024$ bytes) is treated and a size is $255 \times 257$, it is difficult to form a product code with an 8-bit Galois field. In addition, when a plurality of code sequences are used and errors are non-uniformly distributed in the plurality of code sequences, a correction performance deteriorates.

The present invention has been made in view of the foregoing circumstances, and general purpose thereof is to provide a technique for improving transmission efficiency during a block encoding process.

In order to achieve the object, according to an aspect of the present invention, an encoding apparatus includes: an input unit operative to input an information sequence; a first encoding unit operative to generate a first code sequence by performing at least a portion of a block encoding process on the information sequence input by the input unit; a second encoding unit operative to generate a second code sequence by performing the block encoding process on a first check symbol sequence in the first code sequence generated by the first encoding unit; and a generating unit operative to generate a third code sequence by combining a second check symbol sequence in the second code sequence generated by the second encoding unit with the information sequence input by the input unit.

According to the above-mentioned aspect, since the third code sequence without the first check symbol sequence is generated, it is possible to improve transmission efficiency during a block encoding process.

According to another aspect of the present invention, an encoding apparatus includes: an input unit operative to input an information sequence; a dividing unit operative to divide the information sequence input by the input unit into a plurality of groups; a first encoding unit operative to generate a first code sequence for each group by performing at least a portion of a block encoding process on a portion of the information sequence corresponding to each of the plurality of groups divided by the dividing unit; a second encoding unit operative to generate a second code sequence for each group by performing the block encoding process on a first check symbol sequence in the first code sequence generated by the first encoding unit; a generating unit operative to generate a third code sequence for each group by combining a second check symbol sequence in the second code sequence generated by the second encoding unit with the portion of the information sequence in each of the plurality of groups divided by the dividing unit so as to be associated with each other; a combining unit operative to combine the third code sequences generated by the generating unit in the plurality of groups; and a third encoding unit operative to generate a fourth code sequence by performing the block encoding process on the third code sequence combined by the combining unit.

According to the above-mentioned aspect, an information sequence is divided into a plurality of groups, and the third code sequence without the first check symbol sequence is generated for each group. Therefore, it is possible to improve transmission efficiency during a block encoding process.

When the information sequence input by the input unit is arranged in a two-dimensional array including a row having a length that is larger than a maximum code length in the block encoding process and a column having a length that is smaller than the maximum code length, the dividing unit may divide the information sequence such that a portion of the information sequence corresponding to one row forms one group. The generating unit may extend the length of each row of the two-dimensional array to perform combination such that the third code sequence is included in one row. The third encoding unit may perform the block encoding process on each column of the third code sequence combined by the combining unit. According to this structure, the dividing unit divides the information sequence such that a portion of the information sequence corresponding to one row of the two-dimensional array that includes a row having a length that is larger than the maximum code length and a column having a length that is smaller than the maximum code length forms one group. Therefore, it is possible to perform a block encoding process on an information sequence having a size that is larger than the maximum code length.

The second encoding unit makes combinations of the first check symbol sequences in the plurality of groups when the block encoding process is performed different from each other according to the orders of the first check symbol sequences. According to this structure, combinations of the first check symbol sequences when the second code sequence is generated are different from each other. Therefore, it is possible to improve an error detection performance.

According to still another aspect of the present invention, a decoding apparatus includes: an input unit operative to, when an encoding apparatus performs at least a portion of a block encoding process on an information sequence to generate a first code sequence, performs the block encoding sequence on a first check symbol sequence in the first code sequence to generate a second code sequence, and combines a second check symbol sequence in the second code sequence with the information sequence, receive the combined sequence of the second check symbol sequence in the second code sequence and the information sequence from the encoding apparatus and input the received sequence; an estimating unit operative to estimate the first code sequence by performing the same block encoding process as that performed by the encoding apparatus to generate the first code sequence on a portion corresponding to the information sequence in the received sequence input by the input unit; a first processing unit operative to detect an error in the first check symbol sequence, on the basis of the first check symbol sequence in the first code sequence estimated by the estimating unit and a portion corresponding to the second check symbol sequence in the received sequence input by the input unit and; and a second processing unit operative to detect an error in the portion corresponding to the information sequence, on the basis of the first check symbol sequence whose error is detected by the first processing unit and the portion corresponding to the information sequence in the received sequence input by the input unit.

According to the above-mentioned aspect, even when a received sequence without the first check symbol sequence is input, the first check symbol sequence is estimated from the received sequence, and error detection is performed on the basis of the first check symbol sequence and the second check symbol sequence. Therefore, it is possible to prevent deterioration of detection accuracy.

According to yet another aspect of the present invention, a decoding apparatus includes: an input unit operative to, when an encoding apparatus divides an information sequence into a plurality of groups, performs at least a portion of a block encoding process on a portion of the information sequence corresponding to each of the plurality of groups to generate a first code sequence for each group, performs the block encoding process on a first check symbol sequence in the first code sequence to generate a second code sequence for each group, combines a second check symbol sequence in the second code sequence with the portion of the information sequence so as to be associated with each other, thereby generating a third code sequence for each group, combines the third code sequences in the plurality of groups, and performs the block encoding process on the combined third code sequence to generate a code sequence including a third check symbol sequence, receive the code sequence including the third check symbol sequence from the encoding apparatus and input the received sequence; an estimating unit operative to estimate the first code sequence for each group by performing the same block encoding process as that performed by the encoding apparatus to generate the first code sequence on a portion corresponding to the information sequence in the received sequence input by the input unit; a first processing unit operative to detect an error in the first check symbol sequence for each group, on the basis of the first check symbol sequence in the first code sequence estimated by the estimating unit and a portion corresponding to the second check symbol sequence in the received sequence input by the input unit; a second processing unit operative to detect an error in the portion corresponding to the information sequence for each group, on the basis of the first check symbol sequence whose error is detected by the first processing unit and the portion corresponding to the information sequence in the received sequence input by the input unit; and a third processing unit operative to correct the error in the portion corresponding to the information sequence, on the basis of the portion corresponding to the information sequence whose error is detected by the second processing unit and portions corresponding to the second check symbol sequence and the third check symbol sequence in the received sequence input by the input unit.

According to the above-mentioned aspect, even when an information sequence is divided into a plurality of groups, a sequence is generated for each group so as not to include the first check symbol sequence, and the generated sequence is received and input, the first check symbol sequence is estimated from the received sequence, and error detection is performed on the basis of the first check symbol sequence and the second check symbol sequence. Therefore, it is possible to prevent deterioration of detection accuracy.

When an error is detected from the first check symbol sequence, the first processing unit may correct the error and output the first check symbol sequence whose error is corrected to the second processing unit. When an error is detected from the portion corresponding to the information sequence, the second processing unit may correct the error. According to this structure, since the error is detected and corrected, it is possible to improve reproduction characteristics.

The encoding apparatus may make combinations of the first check symbol sequences in the plurality of groups when the block encoding process for generating the second code sequence is performed different from each other according to the orders of the first check symbol sequences, and the first processing unit may detect and correct the error using error detection information in the first check symbol sequences having different orders as erasure error information. According to this structure, it is possible to improve an error detection performance.

The third processing unit may perform erasure error correction as error correction while using the error detection information of each of the first code sequences as the erasure error information. According to this structure, since the error detection information of each of the first code sequences is used as the erasure error information, it is possible to effectively perform error separation.

According to still yet another aspect of the present invention, an encoding method includes: generating a first code sequence by performing at least a portion of a block encoding process on an input information sequence; generating a second code sequence by performing the block encoding process on a first check symbol sequence in the generated first code sequence; and generating a third code sequence by combining a second check symbol sequence in the generated second code sequence with the input information sequence.

According to yet still another aspect of the present invention, an encoding method includes: dividing an input information sequence into a plurality of groups; generating a first code sequence for each group by performing at least a portion of a block encoding process on a portion of the information sequence corresponding to each of the plurality of divided groups; generating a second code sequence for each group by performing the block encoding process on a first check symbol sequence in the generated first code sequence; generating a third code sequence for each group by combining a second check symbol sequence in the generated second code sequence with the portion of the information sequence in each of the plurality of divided groups so as to be associated with each other; combining the generated third code sequences of the plurality of groups; and generating a fourth code sequence by performing the block encoding process on the combined third code sequence.

In generating the second code sequence for each group, combinations of the first check symbol sequences in the plurality of groups when the block encoding process is performed may be different from each other according to the order of the first check symbol sequence.

According to still yet another aspect of the present invention, a decoding method includes: when an encoding apparatus performs at least a portion of a block encoding process on an information sequence to generate a first code sequence, performs the block encoding sequence on a first check symbol sequence in the first code sequence to generate a second code sequence, and combines a second check symbol sequence in the second code sequence with the information sequence, receiving the combined sequence of the second check symbol sequence in the second code sequence and the information sequence from the encoding apparatus and inputting the received sequence; estimating the first code sequence by performing the same block encoding process as that performed by the encoding apparatus to generate the first code sequence on a portion corresponding to the information sequence in the received sequence; detecting an error in the first check symbol sequence, on the basis of the first check symbol sequence in the estimated first code sequence and the second check symbol sequence in the received sequence; and detecting an error in the portion corresponding to the information sequence in the received sequence, on the basis of the first check symbol sequence whose error is detected and the portion corresponding to the information sequence in the received sequence.

According to yet still another aspect of the present invention, a decoding method includes: when an encoding apparatus divides an information sequence into a plurality of groups, performs at least a portion of a block encoding process on a portion of the information sequence corresponding to each of the plurality of groups to generate a first code sequence for each group, performs the block encoding process on a first check symbol sequence in the first code sequence to generate a second code sequence for each group, combines a second check symbol sequence in the second code sequence with the portion of the information sequence so as to be associated with each other, thereby generating a third code sequence for each group, combines the third code sequences of the plurality of groups, and performs the block encoding process on the combined third code sequence to generate a code sequence including a third check symbol sequence, receiving the code sequence including the third check symbol sequence from the encoding apparatus and inputting the received sequence; estimating the first code sequence for each group by performing the same block encoding process as that performed by the encoding apparatus to generate the first code sequence on a portion corresponding to the information sequence in the received sequence; detecting an error in the first check symbol sequence for each group, on the basis of the first check symbol sequence in the estimated first code sequence and a portion corresponding to the second check symbol sequence in the received sequence; detecting an error in the portion corresponding to the information sequence, on the basis of the first check symbol sequence whose error is detected and the portion corresponding to the information sequence in the received sequence; and correcting the error in the portion corresponding to the information sequence, on the basis of the portion corresponding to the information sequence whose error is detected and portions corresponding to the second check symbol sequence and the third check symbol sequence in the received sequence.

In correcting the error in the portion corresponding to the information sequence, erasure error correction may be performed as the error correction while using error detection information of each of the first code sequences as erasure error information.

Furthermore, combinations of the above-mentioned components are included in the scope of the present invention, and modifications of an apparatus, a method, a system, a recording medium, and a computer program may also be included in the scope of the invention.

The invention will be now described by way of example with reference to the accompanying drawings, throughout which like parts are referred to by like references, and in which:

Fig. 1 is a diagram illustrating the structure of a recording apparatus according to a first embodiment of the present invention;
Fig. 2 is a diagram illustrating the structure of data input to a dividing unit shown in Fig. 1;
Fig. 3 is a diagram illustrating the structure of a code sequence generated by a first encoding unit and a second encoding unit shown in Fig. 1;
Fig. 4 is a diagram illustrating the structure of a code sequence generated by a generating unit and a combining unit shown in Fig. 1;
Fig. 5 is a diagram illustrating the structure of a code sequence generated by a third encoding unit shown in Fig. 1;
Fig. 6 is a diagram illustrating the structure of a frame generated by a format unit shown in Fig. 1;
Fig. 7 is a diagram illustrating the structure of a reproducing apparatus according to the first embodiment of the present invention;
Fig. 8 is a diagram illustrating the outline of an operation of using a CRC code to correct an erasure pointer, which is a comparative example of the operation of the reproducing apparatus shown in Fig. 7;
Fig. 9 is a diagram illustrating the outline of an erasure pointer correcting operation of the third processing unit shown in Fig. 7;
Fig. 10 is a flowchart illustrating an encoding process of the recording apparatus shown in Fig. 1;
Fig. 11 is a flowchart illustrating a decoding process of the reproducing apparatus shown in Fig. 7;
Fig. 12 is a diagram illustrating the structure of a partial encoding unit according to a second embodiment of the present invention;
Fig. 13 is a diagram illustrating the structure of a code sequence generated by a first encoding unit shown in Fig. 12;
Fig. 14 is a diagram illustrating a changing rule of a changing unit shown in Fig. 12;
Fig. 15 is a diagram illustrating another changing rule of the changing unit shown in Fig. 12;
Fig. 16 is a diagram illustrating the structure of a partial decoding unit according to the second embodiment of the present invention; and
Fig. 17 is a flowchart illustrating an encoding process according to the second embodiment of the present invention.

The invention will now be described by reference to the preferred embodiments. This does not intend to limit the scope of the present invention, but to exemplify the invention.

(First embodiment)

Before exemplary embodiments of the present invention are described, the outline of the present invention is described. A first embodiment of the present invention relates to a recording apparatus that performs RS encoding on data of 64 kbytes or more to record the data on a recording medium and a reproducing apparatus that performs RS decoding on data recorded on a recording medium to reproduce the data. As described above, it is necessary to improve the efficiency of RS encoding performed on data having a large size of 64 kbytes or more, for example, transmission efficiency. In addition, an RS encoding method which is more efficient and has a higher correction performance than a pointer erasure method is needed. In order to meet at least one of the necessities, the recording apparatus and the reproducing apparatus according to the first embodiment perform the following processes.

When $2^8$ Galois fields are defined as an RS code, the maximum code length of the RS code is $2^8 - 1$. The recording apparatus arranges data in a two-dimensional array (hereinafter, referred to as a "first array") having one side with a length that is equal to or smaller than the maximum code length and the other side with a length that is larger than the maximum code length. For example, one side corresponds to a column component, and the other side corresponds to a row component. In addition, the recording apparatus extracts one row component from the first array and arranges the row components in a two-dimensional array (hereinafter, referred to as a "second array") having two sides with a length that is equal to or smaller than the maximum code length. Further, the recording apparatus generates a product code for the second array. The generated product code includes the above-mentioned parities P, Q, and R. The recording apparatus removes the parities P and Q, and leaves only the parity R. The recording apparatus adds the parity R to the rear of the row component, and returns to the first array. In this case, the length of the row component in the first array is increased by a value corresponding to the parity R (hereinafter, such a first array is also referred to as a "first array"). The above-mentioned processes are performed on each column component. The recording apparatus performs RS encoding on each row component in the first array. As a result, parities S and T are generated.

The reproducing apparatus performs reverse processes of the recording apparatus. That is, the reproducing apparatus performs RS encoding on data arranged in the second array to estimate at least one of the parities P and Q. In this embodiment, it is assumed that the reproducing apparatus estimates the parity Q. The reproducing apparatus performs syndrome calculation on the parities Q and R to detect the error of the parity Q. In addition, the reproducing apparatus performs syndrome calculation on data and the parity Q whose errors are detected to detect the error of the data. Further, the reproducing apparatus returns the data whose error is detected to the first array, and uses the parities S and T to perform syndrome calculation, thereby correcting the error of the data.

Fig. 1 is a diagram illustrating the structure of a recording apparatus 100 according to the first embodiment of the present invention. The recording apparatus 100 includes an RS encoding unit 10, a format unit 12, a record modulating unit 14, a record output unit 16, a control unit 18, and a recording unit 20. The RS encoding unit 10 includes an input unit 22, a dividing unit 24, a partial encoding unit 26, a combining unit 28, and a third encoding unit 30. The partial encoding unit 26 includes a first encoding unit 32, a second encoding unit 34, and a generating unit 36.

The input unit 22 inputs data to be recorded in the recording apparatus 100, that is, data to be subjected to RS encoding. In this embodiment, it is assumed that data is processed in the unit of 64 kbytes. The dividing unit 24 receives data from the input unit 22. Fig. 2 is a diagram illustrating the structure of data input to the dividing unit 24. In Fig. 2, 64-kbyte data are arranged in a matrix of 512 $\times$ 128 bytes. This corresponds to a first array of 128 rows by 512 columns. In the first array, it is possible to generate an RS code sequence with $2^8$ Galois fields in the vertical direction of 128 bytes, that is, a column component, but it is difficult to generate an RS code sequence in the horizontal direction of 512 bytes, that is, a row component. That is, the first array is formed by a two-dimensional array including a row with a length that is larger than the maximum code length of RS encoding and a column with a length that is smaller than the maximum code length.

Referring to Fig. 1 again, the dividing unit 24 divides the first array into a plurality of groups to generate a plurality of second arrays. Specifically, the dividing unit 24 extracts data corresponding to one row of the first array shown in Fig. 2, and performs division such that data corresponding to one row is one group. The one group corresponds to one second array. The above-mentioned process is performed on each row of the first array. Fig. 3 is a diagram illustrating the structure of a code sequence generated by the first encoding unit 32 and the second encoding unit 34. In this embodiment, among data shown in Fig. 3, only data generated by the dividing unit 24 will be described. One row shown in Fig. 2 has 512 bytes. As shown in Fig. 2, the dividing unit 24 arranges 512-byte data in a matrix of 16 bytes by 32 bytes.

Referring to Fig. 1 again, the first encoding unit 32 performs at least a portion of the RS encoding process defined by a product code on data corresponding to each of the plurality of second arrays divided by the dividing unit 24 to generate a first code sequence for each second array. The product code includes RS encoding in the row direction of the second array and RS encoding in the column direction of the second array. The parity P is generated by the RS encoding in the row direction, and the parity Q is generated by the RS encoding in the column direction. Since the first encoding unit 32 performs only the RS encoding in the column direction of the second array, the first code sequence includes only the parity Q.

The primitive polynomial of the Galois field is represented by Expression 1 given below.

[Expression 1]

$$\alpha^8+\alpha^4+\alpha^3+\alpha^2+1=0$$

In addition, the generating polynomial of the first code sequence is represented by Expression 2 given below.

[Expression 2]

$$g(x) = \prod_{i=0}^{3} (x + \alpha^{i})$$

When the parities Q generated in first, i-th, and 32nd columns in Fig. 3 are $q_0(x)$, $q_i(x)$, and $q_{31}(x)$, the parities are represented by Expression 3 given below.

[Expression 3]

$$q_0(x) = q_{03}x^3 + q_{02}x^2 + q_{01}x + q_{00}$$
$$q_i(x) = q_{i3}x^3 + q_{i2}x^2 + q_{i1}x + q_{i0}$$
$$q_{31}(x) = q_{313}x^3 + q_{312}x^2 + q_{311}x + q_{310}$$

The same parity P may be generated. However, as described above, in this embodiment, since the generation of the parity P is omitted, a description thereof will also not be repeated.

The first code sequence output from the first encoding unit 32 is input to the second encoding unit 34. The second encoding unit 34 performs RS encoding on the parity Q in the first code sequence to generate a second code sequence for each second array. Specifically, the second encoding unit 34 uses the above-mentioned generating polynomial for rows having the parity Q, that is, a set of parities having the same dimension, for example, $q_{03}(x)$, $q_{13}$(x, ..., $q_{i3}(x)$, ..., $q_{313}(x)$ to generate the parities R of the rows. In addition, the second encoding unit 34 performs the same process as described above on rows having parities other than the parity Q to generate the parities R. In the parities R, a component $r_3(x)$ corresponding to one row is represented by Expression 4 given below.

[Expression 4]

$$r_3(x) = r_{33}x^3 + r_{32}x^2 + r_{31}x + r_{30}$$

In addition, components $r_2(x)$, $r_1(x)$, and $r_0(x)$ corresponding to the other rows are similarly represented.

Fig. 3 is a diagram illustrating the structure of the code sequence generated by the first encoding unit 32 and the second encoding unit 34. In the code sequence, data has already been described. In the columns having data arranged therein, the parities Q are arranged from a 17th row to a 20th row. The parities Q include 4 × 32 components. In addition, the parities R are arranged from the 17th row to the 20th row and from a 33rd column to a 36th column. The parities R include 4 × 4 components. In the rows having data arranged therein, the parities P may be arranged from the 33rd column to the 36th column. However, as described above, in this embodiment, a description thereof will not be repeated.

Referring to Fig. 1 again, the generating unit 36 combines the parity R in the second code sequence generated by the second encoding unit 34 with data in the second array so as to be associated with each other, thereby generating a third code sequence for each group. In this case, the third code sequence includes only data and the parity R. As described above, since data in the second array corresponds to one row of the first array, the generating unit 36 extends the length of each row in the first array to combine the parity and data such that the third code sequence is included in one row. That is, the generating unit 36 discards the parity Q, and uses data and the parity R to generate one row of the first array. In addition, a plurality of third code sequences is generated to correspond to a plurality of second arrays.

The combining unit 28 combines the plurality of third code sequences generated by the generating unit 36. As a result, a two-dimensional array (as described above, this is also referred to as a "first array") having row components with a length that is larger than that of the first array is generated. Fig. 4 is a diagram illustrating the structure of a code sequence generated by the generating unit 36 and the combining unit 28. The structure of data is the same as that shown in Fig. 2. The parities R are arranged from a 513th column to a 528th column. The parities R include 128 × 16 components.

Referring to Fig. 1 again, the third encoding unit 30 performs RS encoding on each column of the first array generated by the combining unit 28. Specifically, a generating polynomial is represented by Expression 5 given below.

[Expression 5]

$$g(x) = \prod_{i=0}^{23} (x + \alpha^i)$$

The third encoding unit 30 performs RS encoding on each column of data in the first array and each row of the parities R in the first array to generate a fourth code sequence including the parities S and T. Fig. 5 is a diagram illustrating the structure of a code sequence generated by the third encoding unit 30. The structures of data and the parity R are the same as those shown in Fig. 4. In the columns having data arranged therein, the parities S are arranged from a 129th row to a 152nd row. The parities S include 24 × 512 components. In the columns having the parities R arranged therein, the parities T are arranged from the 129th row to the 152nd row.

Referring to Fig. 1 again, the format unit 12 divides data in the fourth code sequence into 132-byte data components, and stores the data components in different frames. In addition, a synchronization signal (SYNC), an address (ADR), an identification (ID) number, and a parity are added to each frame. Fig. 6 is a diagram illustrating the structure of the frame generated by the format unit 12. The SYNC, the ADR, the ID number, a parity, and data are arranged from the head of the frame, and include 2 bytes, 2 bytes, 2 bytes, 2 bytes, and 132 bytes, respectively.

Referring to Fig. 1 again, the record modulating unit 14 receives a plurality of frames from the format unit 12. The record modulating unit 14 performs, for example, 8-16 modulation. A known 8-16 modulation technique may be used, and thus a description thereof will be omitted in this embodiment. In addition, the record modulating unit 14 may perform modulations other than the 8-16 modulation according to the kind of recording unit 20, that is, the kind of recording mediums. The record output unit 16 receives the modulation result from the record modulating unit 14, and records the modulation result on the recording unit 20. The recording unit 20 is composed of a recording medium, such as a blu-ray disk (BD ), a digital versatile disk (DVD ), a compact disc (CD ), a hard disk (HD ), a silicon disk (SD ), or a memory, and the demodulation result is recorded on the recording unit. The recording unit 20 may be fixed to the recording apparatus 100, it may be removable from the recording apparatus 100, or it may be connected to the recording apparatus 100 wirelessly or by wire. The control unit 18 controls the overall operation of the recording apparatus 100.

This structure may be implemented by an LSI, a memory, and a CPU of a computer in a hardware manner, and this structure may be implemented by a program loaded to the memory in a software manner. In this embodiment, functional blocks are implemented by a combination of the hardware and software manners. Therefore, it will be understood by those skilled in the art that the functional blocks are implemented by only hardware, only software, or a combination thereof.

Fig. 7 is a diagram illustrating the structure of a reproducing apparatus 200 according to the first embodiment of the present invention. The reproducing apparatus 200 includes a record input unit 210, a record demodulating unit 212, a deformat unit 214, an RS decoding unit 216, a control unit 218, and a recording unit 220. The RS decoding unit 216 includes an input unit 222, a partial decoding unit 224, a third processing unit 226, and an output unit 228. The partial decoding unit 224 includes an estimating unit 230, a first processing unit 232, and a second processing unit 234.

The recording unit 220 corresponds to the recording unit 20 shown in Fig. 1. The recording unit 220 may be the same as or different from the recording unit 20. The record input unit 210 reads out a signal from the recording unit 220. The read signal corresponds to the above-mentioned modulation result. The record demodulating unit 212 receives the modulation result from the record input unit 210, and demodulates the modulation result. In addition, the record demodulating unit 212 performs demodulation corresponding to the modulation scheme of the record modulating unit 14 shown in Fig. 1. The deformat unit 214 receives the demodulation result from the record demodulating unit 212, detects the SYNC shown in Fig. 6, and generates the first array shown in Fig. 5 on the basis of the ADR.

The input unit 222 receives the first array from the deformat unit 214. The first array is also called a received sequence. The input unit 222 divides the first array into rows, and outputs components included in each row to the estimating unit 230. The estimating unit 230 receives the components included in each row from the input unit 222. The estimating unit 230 and the first and second processing units 232 and 234 process the components included in each row. However, for clarity of description, processes performed on the components included in one row will be described below. Components included in the other rows are similarly processed. The estimating unit 230 performs the same RS encoding process as that for generating the first code sequence in the first encoding unit 32 of the recording apparatus 100 (not shown) on components corresponding to data among the components included in one row, thereby estimating the first code sequence. As described above, since the recording apparatus 100 (not shown) deletes the generated parity Q, the parity Q is not included in the received sequence. Therefore, the estimating unit 230 generates the parity Q from a portion corresponding to data.

The first processing unit 232 performs syndrome calculation on the parity Q in the first code sequence estimated by the estimating unit 230 and components corresponding to the parity R among the components included in one row output from the input unit 222. As a result, the error of the parity Q is detected. In this case, the second array shown in Fig. 3 is formed, and the syndrome calculation is performed on 17th to 20th rows of the second array, respectively. In addition, during the syndrome calculation, the generating polynomial of the first code sequence in the first encoding unit 32 is used. If all the syndromes are "0", there is no error in the corresponding row. However, if all the syndromes are not "0", the first processing unit 232 detects the error of the row, and corrects the error. In this case, an error of 2 bytes or less can be corrected. When the error correction is unavailable, that is, when there is an error of 3 bytes or more, the first processing unit 232 regards the entire row as an error and places an erasure pointer in the row. The first processing unit 232 outputs any one of the parity Q to be checked that it has no error, the parity Q whose error is corrected, and the parity Q having an erasure pointer placed therein to the second processing unit 234.

The second processing unit 234 receives the parity Q from the first processing unit 232. The second processing unit 234 performs syndrome calculation on the parity Q output from the first processing unit 232 and components corresponding to data among the components included in one row output from the input unit 222. As a result, the errors of the components corresponding to data are detected. In this case, the syndrome calculation is performed on 1st to 32nd columns of the second array. In addition, during the syndrome calculation, the generating polynomial of the first code sequence in the first encoding unit 32 is used. If a syndrome is "0", there is no error in the corresponding column.

However, if the syndrome is not "0", the second processing unit 234 detects the error of the column, and corrects the error. In this case, an error of 2 bytes or less can be corrected. When the error correction is unavailable, that is, when there is an error of 3 bytes or more, the second processing unit 234 regards the entire column as an error and places an erasure pointer in the column. This process narrows down a position including an error. In this embodiment, erasure pointers can be placed in arbitrary two columns having errors. The second processing unit 234 outputs any one of a portion corresponding to data to be checked that it has no error, a portion corresponding to data whose error is corrected, and a portion corresponding to data having an erasure pointer placed therein to the third processing unit 226.

The third processing unit 226 receives a portion corresponding to data from the second processing unit 234, and generates the first array shown in Fig. 5. The third processing unit 226 performs syndrome calculation on a portion corresponding to data in the first array and the parities R, S, and T. As a result, the error of the portion corresponding to data is corrected. In this case, the syndrome calculation is performed on each column of the first array. The generating polynomial of the third code sequence in the third encoding unit 30 is used for the syndrome calculation. The third processing unit 226 corrects the portion corresponding to data on the basis of the syndrome calculation results and erasure pointer information.

Fig. 8 is a diagram illustrating the outline of an operation of using a CRC code to correct an erasure pointer, which is a comparative example of the reproducing apparatus 200. The structure shown in Fig. 8 is the same as that shown in Fig. 5. In Fig. 8, a dashed line corresponds to a row having an error. That is, the dashed line corresponds to a row having an erasure pointer placed therein. In the related art, the CRC code is used to process data of 256 bytes or more. In this case, as shown in Fig. 8, it is assumed that all data components in one row have errors.

Fig. 9 is a diagram illustrating the outline of the operation of the third processing unit 226 correcting the erasure pointer. The error range is limited to 16 bytes by the processes of the first processing unit 232 and the second processing unit 234 performed on the second array. As a result, the overlap of an error row generating the parity S is reduced, and the correction performance of the third processing unit 226 is improved. That is, a pointer erasure method of correcting errors while using error detection information for each first code sequence as an erasure pointer is performed. The performance of the above-mentioned operation greatly depends on the reproduction error of a second check symbol sequence. Therefore, it is possible to improve a correction performance by detecting and correcting the error of the second check symbol sequence with the fourth code sequence and performing the above-mentioned operation from the beginning. Referring to Fig. 1 again, the output unit 228 receives data whose error is corrected from the third processing unit 226, and outputs the received data as reproduction data. The control unit 218 controls the overall operation of the reproducing apparatus 200.

Next, the operation of the recording apparatus 100 having the above-mentioned structure will be described. Fig. 10 is a flowchart illustrating an encoding process of the recording apparatus 100. The dividing unit 24 divides data into 128 groups (S10). The first encoding unit 32 sets a group number to "1" (S12). The first encoding unit 32 calculates the parity Q (S14). The second encoding unit 34 calculates the parity R (S16). The generating unit 36 combines data with the parity R (S18). The first encoding unit 32 adds 1 to the group number (S20). If the group number is smaller than 128 (S22: N), the process returns to Step 14. If the group number is larger than 128 (S22: Y), the combining unit 28 combines data and the parity R in each group. The third encoding unit 30 calculates the parities S and T (S24).

Next, the operation of the reproducing apparatus 200 having the above-mentioned structure will be described. Fig. 11 is a flowchart illustrating a decoding process of the reproducing apparatus 200. The input unit 222 divides data into 128 groups (S40). The estimating unit 230 sets a group number to "1" (S42). The estimating unit 230 generates the parity Q (S44). The first processing unit 232 detects and corrects the error of the parity Q (S46). The second processing unit 234 detects and corrects the error of a portion corresponding to data (S48). The estimating unit 230 adds 1 to the group number (S50). If the group number is smaller than 128 (S52: N), the process returns to Step 44. If the group number is larger than 128 (S52: Y), the third processing unit 226 uses the parities S and T to perform error correction (S54).

According to this embodiment of the present invention, data is divided into a plurality of groups, and a third code sequence without the parity Q is generated for each group. Therefore, it is possible to improve transmission efficiency. Also, after RS encoding is performed on the second array, RS encoding is performed in the direction of the first array having a length that is equal to or smaller than the maximum code length. Therefore, it is possible to perform RS encoding even when data has a large size. Also, the first array is divided such that data corresponding to one row forms one group. Therefore, even when data has a size that is larger than the maximum code length, RS encoding can be performed on the data. Further, even when a received sequence that is generated for each group so as not to include the parity Q is input after data is divided into a plurality of groups, the parity Q is estimated from the received sequence, and error detection is performed on the basis of the parities Q and R. Therefore, it is possible to decode a code sequence generated by block encoding with improved transmission efficiency and prevent the deterioration of detection accuracy. Also, since both error detection and error correction are performed, it is possible to improve reproduction characteristics.

Furthermore, since the parity Q is not transmitted and recorded, it is possible to reduce redundancy and improve transmission efficiency. Also, it is possible to narrow down an error range, as compared to a structure in which a CRCC is added as an error detection code in the row direction. Therefore, it is possible to improve a correction performance of outer codes. Also, it is possible to treat data having a length that is larger than the maximum code length of an RS code defined by the Galois field, and performs the generation and correction of codes using a small circuit. Further, since an outer code is added, it is possible to improve a correction performance using a small circuit. Furthermore, since the error range is limited to 16 bytes, it is possible to reduce the overlap of an error row generating the parity S, and improve a correction performance.

(Second embodiment)

In the first embodiment, the parity R is used to detect the error of a 16-byte column parity. As described above, the parities R are arranged in 4 rows. However, since 4 rows of the parities all detect the error of the same column, the parities are redundantly used to detect the error of a column. Therefore, in a second embodiment, 4 rows of parities detect errors of different columns in order to improve the efficiency of parity and an error correction performance. In the second embodiment, a recording apparatus generates parities Q, and combines the parities with different orders for each of four groups to generate parities R.

Fig. 12 is a diagram illustrating the structure of a partial encoding unit 26 according to the second embodiment of the present invention. The partial encoding unit 26 includes a first encoding unit 32, a changing unit 40, a second encoding unit 34, and a generating unit 36. As described above, the first encoding unit 32 generates a first code sequence. Fig. 13 is a diagram illustrating the structure of a code sequence generated by the first encoding unit 32. Fig. 13 shows data and parities Q for four groups. That is, the four groups include 1st to 32nd columns (hereinafter, referred to as "group 1"), 33rd to 64th columns (hereinafter, referred to as "group 2"), 65th to 96th columns (hereinafter, referred to as "group 3"), and 97th to 128th columns (hereinafter, referred to as "group 4"). Since each of the groups corresponds to one row of the first array shown in Fig. 4, four rows are extracted from the first array shown in Fig. 4 to generate the code sequence shown in Fig. 13. The parities Q included in the group 1 are represented by $Q_{30}$, $Q_{20}$, $Q_{10}$, and $Q_{00}$. This is similarly applied to the groups 2 to 4.

Referring to Fig. 12 again, the changing unit 40 changes combinations of the parities Q (hereinafter, simply referred to as "parities Q") in the first code sequence generated by the first encoding unit 32 for 4 groups. Fig. 14 shows a conversion rule of the changing unit 40. Fig. 14 shows the combined groups 1 to 4, similar to Fig. 13. In Fig. 14, a combination of the parities Q for generating the parity R is changed for each row. Specifically, in a 17th row, a combination of the parities Q for changing the parity R is not changed. For example, the parity $Q_{30}$ is used without any change in order to generate a parity $R_{30}$. In an 18th row, a combination for generating the parity R such that the parity Q is shifted to the right side by 8 columns, that is, in a direction in which the column number is increased is defined. For example, the parities Q in 9th to 40th columns are used to generate a parity $R_{20}$. In the 19th and 20th rows, combinations for generating the parities R that the parity Q is shifted to the right side by 16 columns and 24 columns are defined, respectively. That is; a combination for generating the parity R is changed depending on the order of each parity Q. Fig. 15 is a diagram illustrating another changing rule of the changing unit 40. In Fig. 15, components of four groups are mixed in one group. Therefore, the components are uniformly grouped.

Referring to Fig. 12 again, the second encoding unit 34 performs RS encoding on the parities Q changed by the changing unit 40. For example, the second encoding unit 34 generates the parity $R_{20}$ on the basis of the parities Q included in the parity $R_{20}$ shown in Fig. 14. The generated code sequence is also referred to as the second code sequence. The processes of the second encoding unit 34 and the generating unit 36 are the same as those in the first embodiment, and thus a description thereof will not be repeated in this embodiment.

Fig. 16 is a diagram illustrating the structure of a partial decoding unit 224 according to the second embodiment of the present invention. The partial decoding unit 224 includes an estimating unit 230, a first processing unit 232, and a second processing unit 234. The process of the estimating unit 230 is the same as that in the first embodiment.

The first processing unit 232 performs syndrome calculation on the parity Q in the first code sequence estimated by the estimating unit 230 and components corresponding to the parity R among the components included in one row output from the input unit 22. The first processing unit 232 corrects a maximum of two errors on the basis of 16 sets of reproduced parities R. When the parity R has two or more errors, or an unspecified number of errors, the first processing unit 232 uses error correction information of another parity to correct an erasure pointer. In this way, a maximum of four error columns are specified.

In Fig. 14, error points are represented by "×". A set of the parities $R_{31}$ and a set of the parities $R_{21}$ have five errors and three errors, respectively. Therefore, the error points are not specified. However, since a set of the parities $R_{11}$ has two errors, a column including the error is specified. An erasure pointer is placed in the column having the error to specify one error column in the set of the parities $R_{21}$. Similarly, since errors are included in only two columns in a set of the parities $R_{20}$, the error columns are specified. As a result, five error columns included in the second row of the first array are specified.

The above-mentioned process will be described in detail below. First, the parity $R_{30}$ is calculated, and then the parity $R_{20}$ is calculated. The parities each have two errors, and it is possible to correct the errors. The error column of the parity $R_{20}$ is added to the parity $R_{10}$ and then calculation is performed. In this case, since there is one error, it is possible to correct the error. The error columns of the parities $R_{20}$ and $R_{10}$ are added to the parity $R_{00}$, and then calculation is performed. In this case, since there is one error, it is difficult to specify an error column. Then, the syndrome of the parity $R_{31}$ is calculated. In the parity $R_{31}$, it has been checked that there are four errors, and the last one error is not specified. Then, the syndrome of the parity $R_{21}$ is calculated. In this parity, it is also difficult to specify an error column. Then, the syndrome of the parity $R_{11}$ is calculated. In this case, it is possible to correct two errors. The error column of the parity $R_{11}$ is added to the parity $R_{01}$, and then calculation is performed. The above-mentioned processes are repeatedly performed. However, since there is no error in Fig. 14, a description thereof will not be repeated in this embodiment.

Since there is no additional error in the parity $R_{01}$, it is possible to verify whether the error of the parity $R_{11}$ is correct. If the error of the parity $R_{11}$ is correct, it is estimated that one error of the parity $R_{11}$ is correct. The error column of the parity $R_{11}$ is added to the parity $R_{21}$ and then calculation is performed again. If newly detected error columns are the same as those of the parity $R_{10}$, it is estimated that all the detected error columns are correct. Then, syndrome calculation is performed on the parity $R_{00}$ again. As a result, the errors of all the error columns and the errors other than the error of the parity $R_{31}$ are corrected. That is, the first processing unit 232 detects and corrects the errors using error detection information in the first check symbol sequences having different orders as an erasure pointer. The error columns of the parity $R_{31}$ are specified, but are not corrected since there are five errors. In this case, the second processing unit 234 processes the parities Q included in the parity $R_{31}$. If there is a data error in each column and it is verified that there is an error in the parity $R_{31}$, it is estimated that all the correcting operations are correct.

Next, the operation of the recording apparatus 100 having the above-mentioned structure will be described. Fig. 17 is a flowchart illustrating an encoding process according to the second embodiment of the present invention. The dividing unit 24 divides data into 128 groups (S70). The first encoding unit 32 sets a group number to "1" (S72). The first encoding unit 32 calculates the parity Q (S74). The changing unit 40 changes the parity Q (S76). The second encoding unit 34 calculates the parity R (S78). The generating unit 36 combines data with the parity R (S80). The first encoding unit 32 adds 1 to the group number (S82). If the group number is smaller than 128 (S84: N), the process returns to Step 74. If the group number is larger than 128 (S84: Y), the combining unit 28 combines data and the parity R between the groups. The third encoding unit 30 calculates the parities S and T (S86).

According to this embodiment of the present invention, a combination of the parities Q for generating the parity R varies depending on the order of the parity Q. Therefore, it is possible to improve an error detection performance. Also, since a combination of the parities Q for generating the parity R varies depending on the order of the parity Q and error points are subdivided, it is possible to reduce the overlap between errors. Also, since the overlap between the errors is reduced, it is possible to improve an outer code correction performance.

The present invention has been described above with reference to the exemplary embodiments. The above-described embodiments are just illustrative, and it will be understood by those skilled in the art that various modifications of the above-mentioned components or processes can be made and the modifications are also included in the scope of the present invention.

In the first and second embodiments of the present invention, the dividing unit 24 divides the first array into a plurality of second arrays, and the partial encoding unit 26 performs RS encoding on each of the second arrays. However, the present invention is not limited thereto. For example, when the size of data to be processed by the recording apparatus 100 is small, the partial encoding unit 26 may perform RS encoding on data arranged in the second array without providing the dividing unit 24. In this case, the input unit 22 inputs data. The first encoding unit 32 arranges data in the second array, and performs at least a portion of the RS encoding process defined by a product code to generate a first code sequence. The second encoding unit 34 performs RS encoding on the parity Q in the first code sequence generated by the first encoding unit 32 to generate a second code sequence. The generating unit 36 combines data and the parity R in the second code sequence generated by the data second encoding unit 34 to generate a third code sequence.

The reproducing apparatus 200 performs an operation corresponding to the recording apparatus 100. The estimating unit 230 performs the same RS encoding process as that for generating the first code sequence on a portion corresponding to data included in the received sequence to estimate the first code sequence. Of the parity Q in the first code sequence estimated by the estimating unit 230 and a portion corresponding to the parity R in the received sequence, the first processing unit 232 detects the error of the parity Q. Of the parity Q whose error is detected by the first processing unit 232 and a portion corresponding to data in the received sequence, the second processing unit 234 detects the error of the portion corresponding to data. According to this modification, since the third code sequence without the parity Q is generated, it is possible to improve transmission efficiency during RS encoding. Also, even when a received sequence without the parity Q is input, the parity Q is estimated from the received sequence, and error detection is performed on the basis of the parity Q and the parity R.
Therefore, it is possible to prevent deterioration of detection accuracy.

In the first and second embodiments of the present invention, the recording apparatus 100 and the reproducing apparatus 200 use RS encoding as block encoding. However, the present invention is not limited thereto. For example, the recording apparatus 100 and the reproducing apparatus 200 may use block encoding other than RS encoding. For example, the recording apparatus 100 and the reproducing apparatus 200 may use BCH encoding. According to this modification, the present invention can be applied to various block encoding processes.
Further inventive features of the present embodiments are defined in the following paragraphs:

1. An encoding apparatus (100) comprising:

an input unit (22) operative to input an information sequence;
a first encoding unit (32) operative to generate a first code sequence by performing at least a portion of a block encoding process on the information sequence input by the input unit (22);
a second encoding unit (34) operative to generate a second code sequence by performing the block encoding process on a first check symbol sequence in the first code sequence generated by the first encoding unit (32); and
a generating unit (36) operative to generate a third code sequence by combining a second check symbol sequence in the second code sequence generated by the second encoding unit (34) with the information sequence input by the input unit (22).

2. A decoding apparatus (200) comprising:

an input unit (222) operative to, when an encoding apparatus (100) performs at least a portion of a block encoding process on an information sequence to generate a first code sequence, performs the block encoding sequence on a first check symbol sequence in the first code sequence to generate a second code sequence, and combines a second check symbol sequence in the second code sequence with the information sequence, receive the combined sequence of the second check symbol sequence in the second code sequence and the information sequence from the encoding apparatus and input the received sequence;
an estimating unit (230) operative to estimate the first code sequence by performing the same block encoding process as that performed by the encoding apparatus to generate the first code sequence on a portion corresponding to the information sequence in the received sequence input by the input unit (222);
a first processing unit (232) operative to detect an error in the first check symbol sequence, on the basis of the first check symbol sequence in the first code sequence estimated by the estimating unit (230) and a portion corresponding to the second check symbol sequence in the received sequence input by the input unit (222); and
a second processing unit (234) operative to detect an error in the portion corresponding to the information sequence, on the basis of the first check symbol sequence whose error is detected by the first processing unit (232) and the portion corresponding to the information sequence in the received sequence input by the input unit (222).

3. An encoding method comprising:

generating a first code sequence by performing at least a portion of a block encoding process on an input information sequence;
generating a second code sequence by performing the block encoding process on a first check symbol sequence in the generated first code sequence ; and
generating a third code sequence by combining a second check symbol sequence in the generated second code sequence with the input information sequence.

4. A decoding method comprising:

when an encoding apparatus performs at least a portion of a block encoding process on an information sequence to generate a first code sequence, performs the block encoding sequence on a first check symbol sequence in the first code sequence to generate a second code sequence, and combines a second check symbol sequence in the second code sequence with the information sequence, receiving the combined sequence of the second check symbol sequence in the second code sequence and the information sequence from the encoding apparatus and inputting the received sequence;
estimating the first code sequence by performing the same block encoding process as that performed by the encoding apparatus to generate the first code sequence on a portion corresponding to the information sequence in the input received sequence;
detecting an error in the first check symbol sequence, on the basis of the first check symbol sequence in the estimated first code sequence and the second check symbol sequence in the input received sequence; and
detecting an error in the portion corresponding to the information sequence in the received sequence, on the basis of the first check symbol sequence whose error is detected and the portion corresponding to the information sequence in the input received sequence.

## Claims

**1.** An encoding apparatus (100) comprising:

an input unit (22) operative to input an information sequence;
a dividing unit (24) operative to divide the information sequence input by the input unit (22) into a plurality of groups;
a first encoding unit (32) operative to generate a first code sequence for each group by performing at least a portion of a block encoding process on a portion of the information sequence corresponding to each of the plurality of groups divided by the dividing unit (24);
a second encoding unit (34) operative to generate a second code sequence for each group by performing the block encoding process on a first check symbol sequence in the first code sequence generated by the first encoding unit (32);
a generating unit (36) operative to generate a third code sequence for each group by combining a second check symbol sequence in the second code sequence generated by the second encoding unit (34) with the portion of the information sequence corresponding to each of the plurality of groups divided by the dividing unit (24) so as to be associated with each other;
a combining unit (28) operative to combine the third code sequences generated by the generating unit (36) for the plurality of groups; and
a third encoding unit (30) operative to generate a fourth code sequence by performing the block encoding process on the third code sequence combined by the combining unit (28).

**2.** The encoding apparatus (100) according to claim 1, wherein
when the information sequence input by the input unit (22) is arranged in a two-dimensional array including a row having a length that is larger than a maximum code length in the block encoding process and a column having a length that is smaller than the maximum code length, the dividing unit (24) divides the information sequence such that a portion of the information sequence corresponding to one row forms one group,
the generating unit (36) extends the length of each row of the two-dimensional array to perform combination such that the third code sequence is included in one row, and
the third encoding unit (30) performs the block encoding process on each column of the third code sequence combined by the combining unit (28).

**3.** The encoding apparatus (100) according to claim 1 or 2, wherein
the second encoding unit (34) makes combinations of the first check symbol sequences in the plurality of groups when the block encoding process is performed different from each other according to the orders of the first check symbol sequences.

**4.** A decoding apparatus (200) comprising:

an input unit (222) operative to, when an encoding apparatus (100) divides an information sequence into a plurality of groups, performs at least a portion of a block encoding process on a portion of the information sequence corresponding to each of the plurality of groups to generate a first code sequence for each group, performs the block encoding process on a first check symbol sequence in the first code sequence to generate a second code sequence for each group, combines a second check symbol sequence in the second code sequence with the portion of the information sequence so as to be associated with each other, thereby generating a third code sequence for each group, combines the third code sequences of the plurality of groups, and performs the block encoding process on the combined third code sequence to generate a code sequence including a third check symbol sequence, receive the code sequence including the third check symbol sequence from the encoding apparatus and input the received sequence;
an estimating unit (230) operative to estimate the first code sequence for each group by performing the same block encoding process as that performed by the encoding apparatus to generate the first code sequence on a portion corresponding to the information sequence in the received sequence input by the input unit (222);
a first processing unit (232) operative to detect an error in the first check symbol sequence for each group, on the basis of the first check symbol sequence in the first code sequence estimated by the estimating unit (230) and a portion corresponding to the second check symbol sequence in the received sequence input by the input unit (222);
a second processing unit (234) operative to detect an error in the portion corresponding to the information sequence for each group, on the basis of the first check symbol sequence whose error is detected by the first processing unit (232) and the portion corresponding to the information sequence in the received sequence input by the input unit (222); and
a third processing unit (226) operative to correct the error in the portion corresponding to the information sequence, on the basis of the portion corresponding to the information sequence whose error is detected by the second processing unit (234) and portions corresponding to the second check symbol sequence and the third check symbol sequence in the received sequence input by the input unit (222).

**5.** The decoding apparatus (200) according to claim 4, wherein
when an error is detected from the first check symbol sequence, the first processing unit (232) corrects the error and outputs the first check symbol sequence whose error is corrected to the second processing unit (234), and when an error is detected from the portion corresponding to the information sequence, the second processing unit (234) corrects the error.

**6.** The decoding apparatus (200) according to claim 4 or 5, wherein
the encoding apparatus (100) makes combinations of the first check symbol sequences in the plurality of groups when the block encoding process for generating the second code sequence is performed different from each other according to the orders of the first check symbol sequences, and
the first processing unit (232) detects and corrects the error using error detection information in the first check symbol sequences having different orders as erasure error information.

**7.** The decoding apparatus (200) according to any one of claims 4 to 6, wherein
the third processing unit (226) performs erasure error correction as error correction while using the error detection information of each of the first code sequences as the erasure error information.

**8.** An encoding method comprising:

dividing an input information sequence into a plurality of groups;
generating a first code sequence for each group by performing at least a portion of a block encoding process on a portion of the information sequence corresponding to each of the plurality of groups;
generating a second code sequence for each group by performing the block encoding process on a first check symbol sequence in the first code sequence;
generating a third code sequence for each group by combining a second check symbol sequence in the generated second code sequence with the portion of the information sequence in each of the plurality of divided groups so as to be associated with each other;
combining the generated third code sequences of the plurality of groups; and
a fourth code sequence generating by performing the block encoding process on the combined third code sequence.

**9.** The encoding method according to claim 8, wherein
in generating the second code sequence for each group, combinations of the first check symbol sequences in the plurality of groups when the block encoding process is performed are different from each other according to the order of the first check symbol sequence.

**10.** A decoding method comprising:

when an encoding apparatus divides an information sequence into a plurality of groups, performs at least a portion of a block encoding process on a portion of the information sequence corresponding to each of the plurality of groups to generate a first code sequence for each group, performs the block encoding process on a first check symbol sequence in the first code sequence to generate a second code sequence for each group, combines a second check symbol sequence in the second code sequence with the portion of the information sequence so as to be associated with each other, thereby generating a third code sequence for each group, combines the third code sequences of the plurality of groups, and performs the block encoding process on the combined third code sequence to generate a code sequence including a third check symbol sequence, receiving the code sequence including the third check symbol sequence from the encoding apparatus and inputting the received sequence;
estimating the first code sequence for each group by performing the same block encoding process as that performed by the encoding apparatus to generate the first code sequence on a portion corresponding to the information sequence in the received sequence;
detecting an error in the first check symbol sequence for each group, on the basis of the first check symbol sequence in the estimated first code sequence and a portion corresponding to the second check symbol sequence in the input received sequence;
detecting an error in the portion corresponding to the information sequence for each group, on the basis of the first check symbol sequence whose error is detected and the portion corresponding to the information sequence in the received sequence; and
correcting the error in the portion corresponding to the information sequence, on the basis of the portion corresponding to the information sequence whose error is detected and portions corresponding to the second check symbol sequence and the third check symbol sequence in the received sequence.

**11.** The decoding method according to claim 10, wherein
in correcting the error in the portion corresponding to the information sequence, erasure error correction is performed as the error correction while using error detection information of each of the first code sequences as erasure error information.

FIG.1

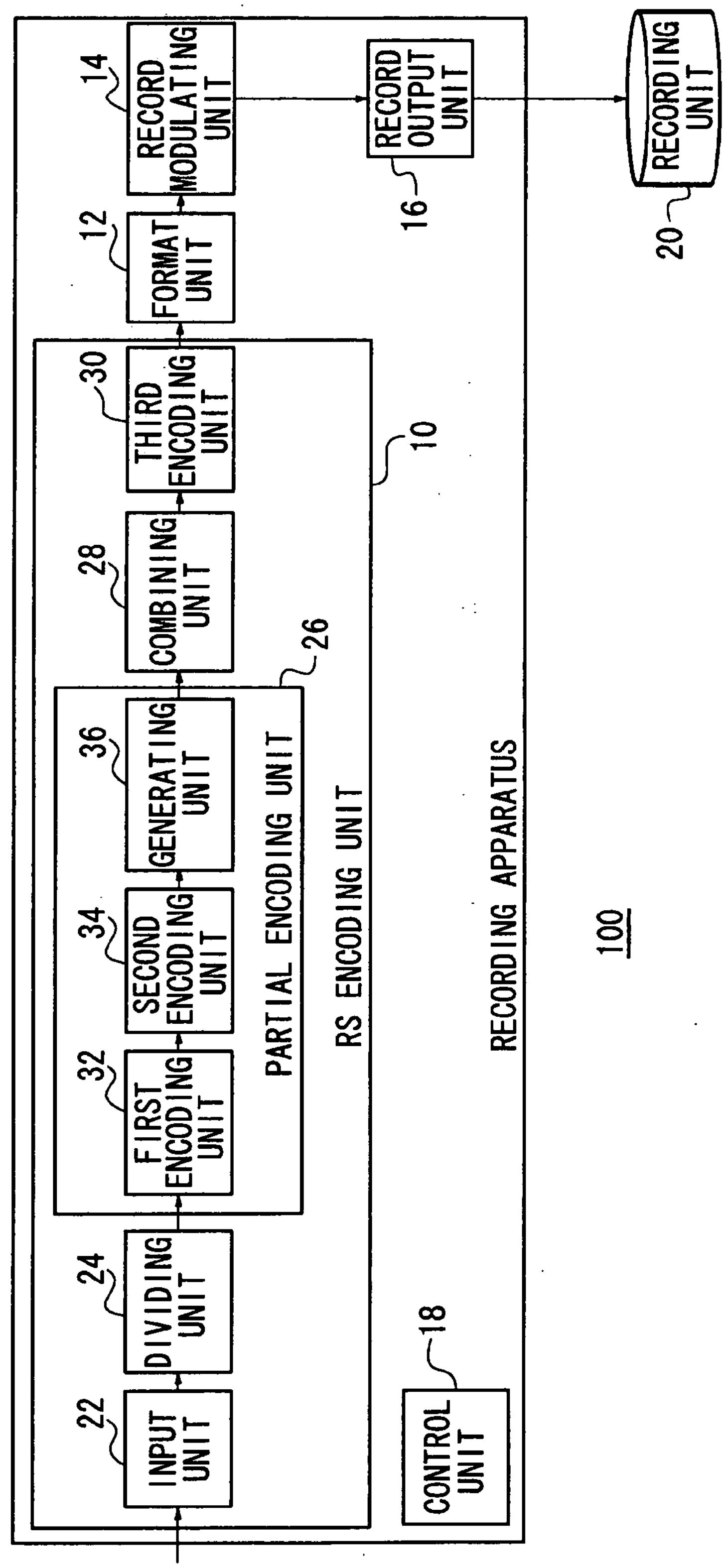
INPUT UNIT
22
DIVIDING UNIT
24
FIRST ENCODING UNIT
32
SECOND ENCODING UNIT
34
GENERATING UNIT
36
PARTIAL ENCODING UNIT
26
COMBINING UNIT
28
THIRD ENCODING UNIT
30
RS ENCODING UNIT
10
FORMAT UNIT
12
RECORD MODULATING UNIT
14
RECORD OUTPUT UNIT
16
CONTROL UNIT
18
RECORDING APPARATUS
100
RECORDING UNIT
20

FIG.2

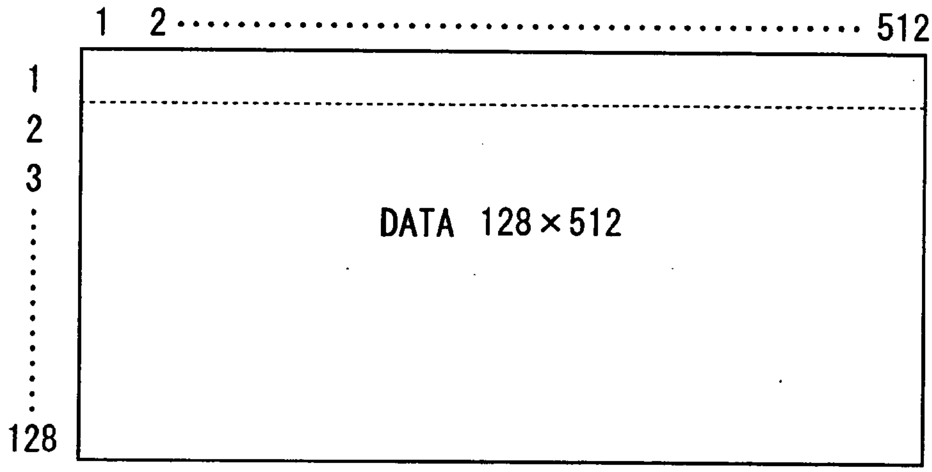
1
2
512
1
2
3
128
DATA 128×512

FIG.3

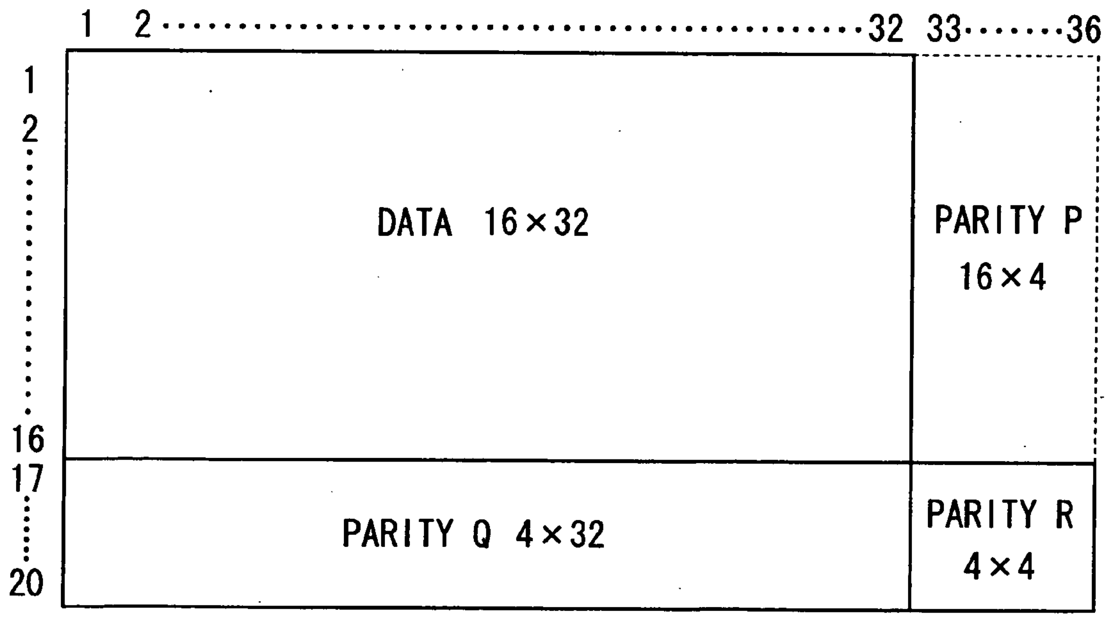
1
2
32
33
36
1
2
16
17
20
DATA 16×32
PARITY P
16×4
PARITY Q 4×32
PARITY R
4×4

FIG.4

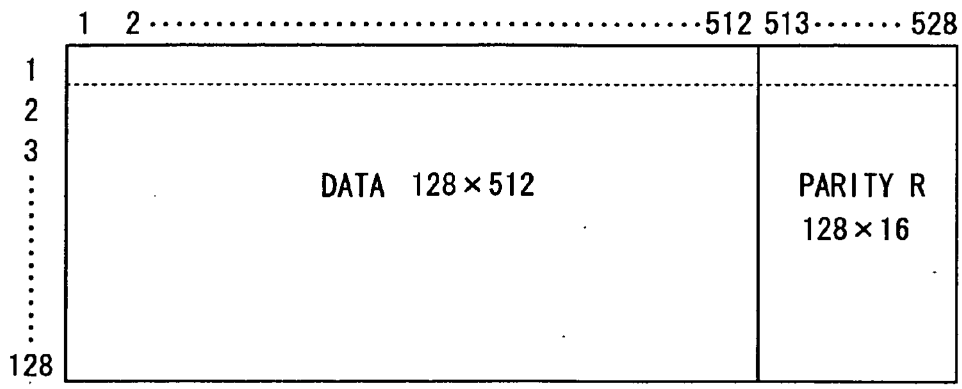


FIG.5

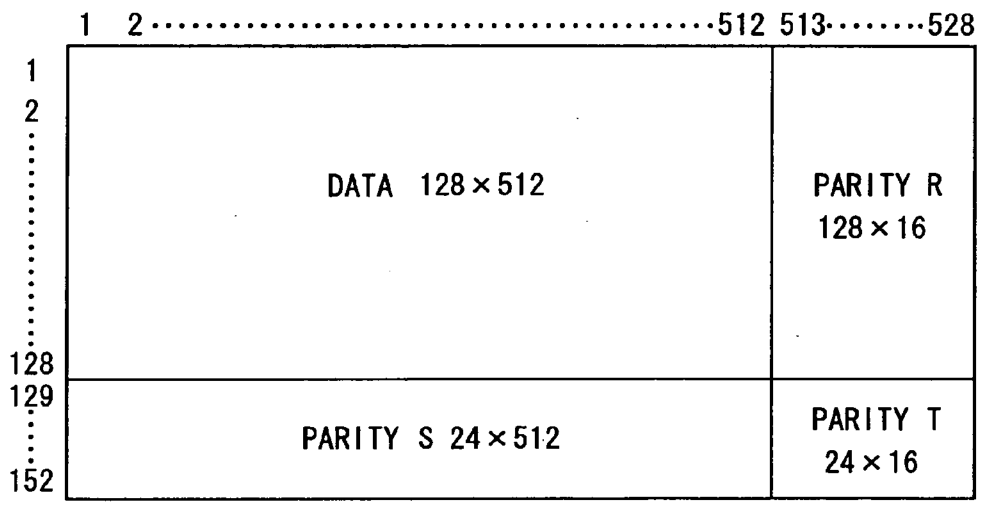


FIG.6

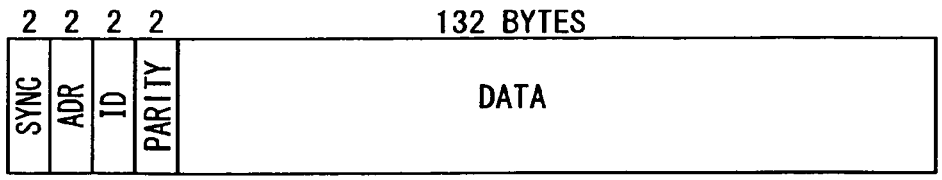

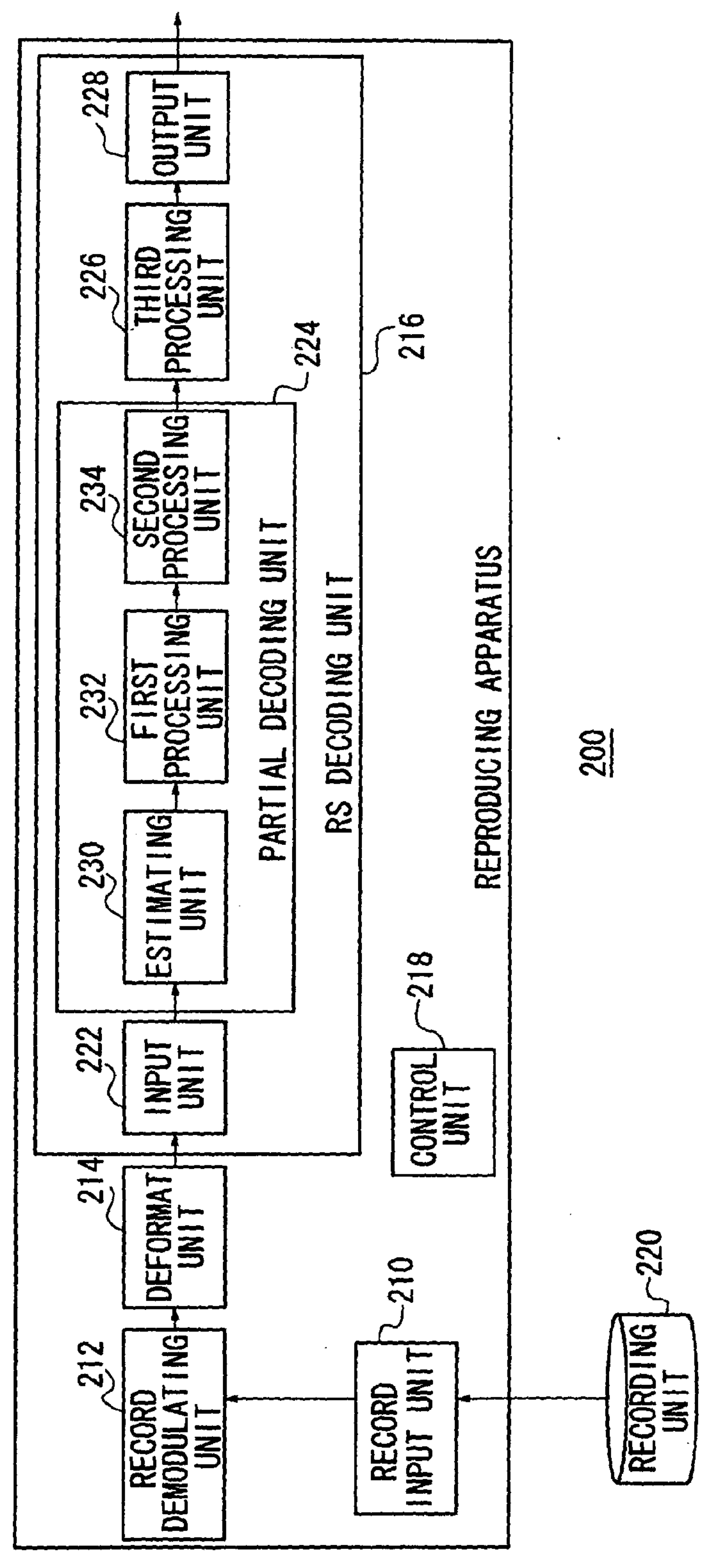
RECORD DEMODULATING UNIT
212
DEFORMAT UNIT
214
INPUT UNIT
222
ESTIMATING UNIT
230
FIRST PROCESSING UNIT
232
SECOND PROCESSING UNIT
234
PARTIAL DECODING UNIT
224
THIRD PROCESSING UNIT
226
OUTPUT UNIT
228
RS DECODING UNIT
216
RECORD INPUT UNIT
210
CONTROL UNIT
218
REPRODUCING APPARATUS
200
RECORDING UNIT
220

FIG.7

FIG.8

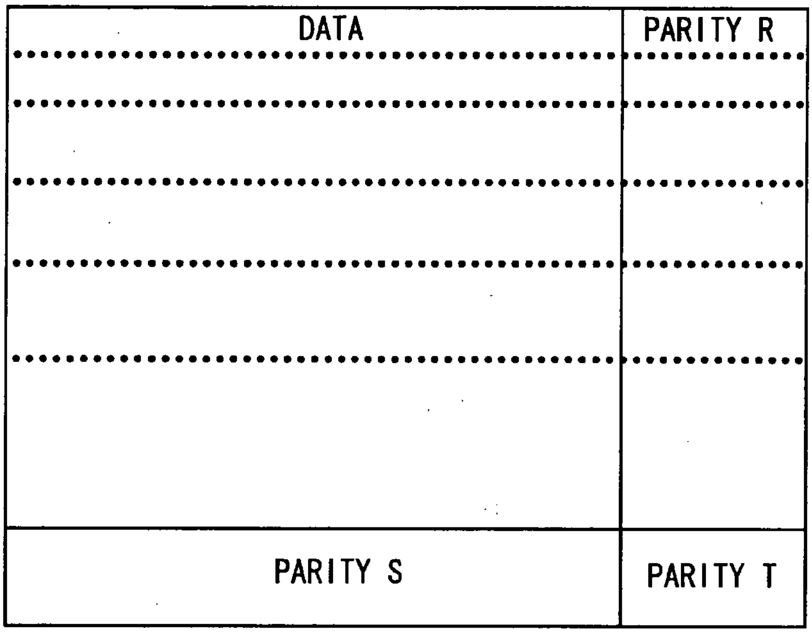
DATA
PARITY R
PARITY S
PARITY T

FIG.9

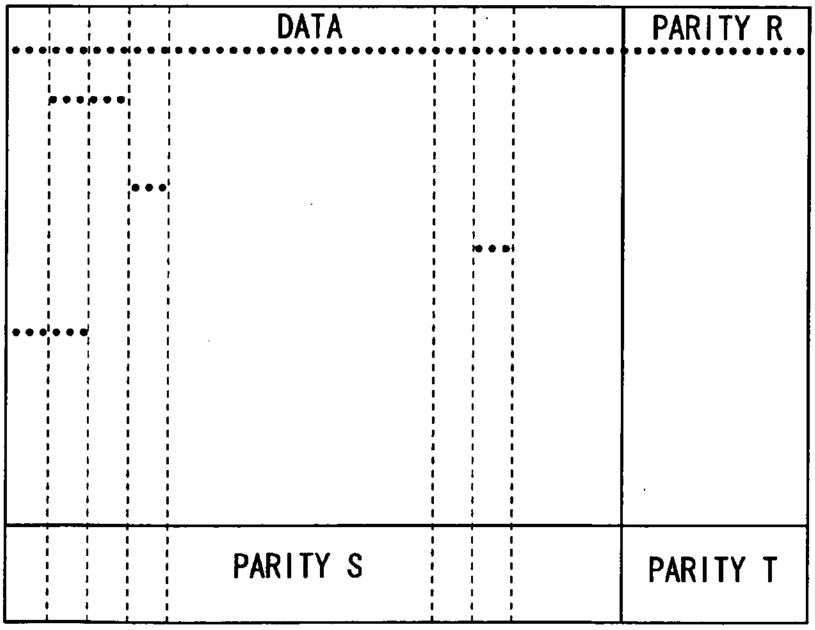
DATA
PARITY R
PARITY S
PARITY T

FIG.10

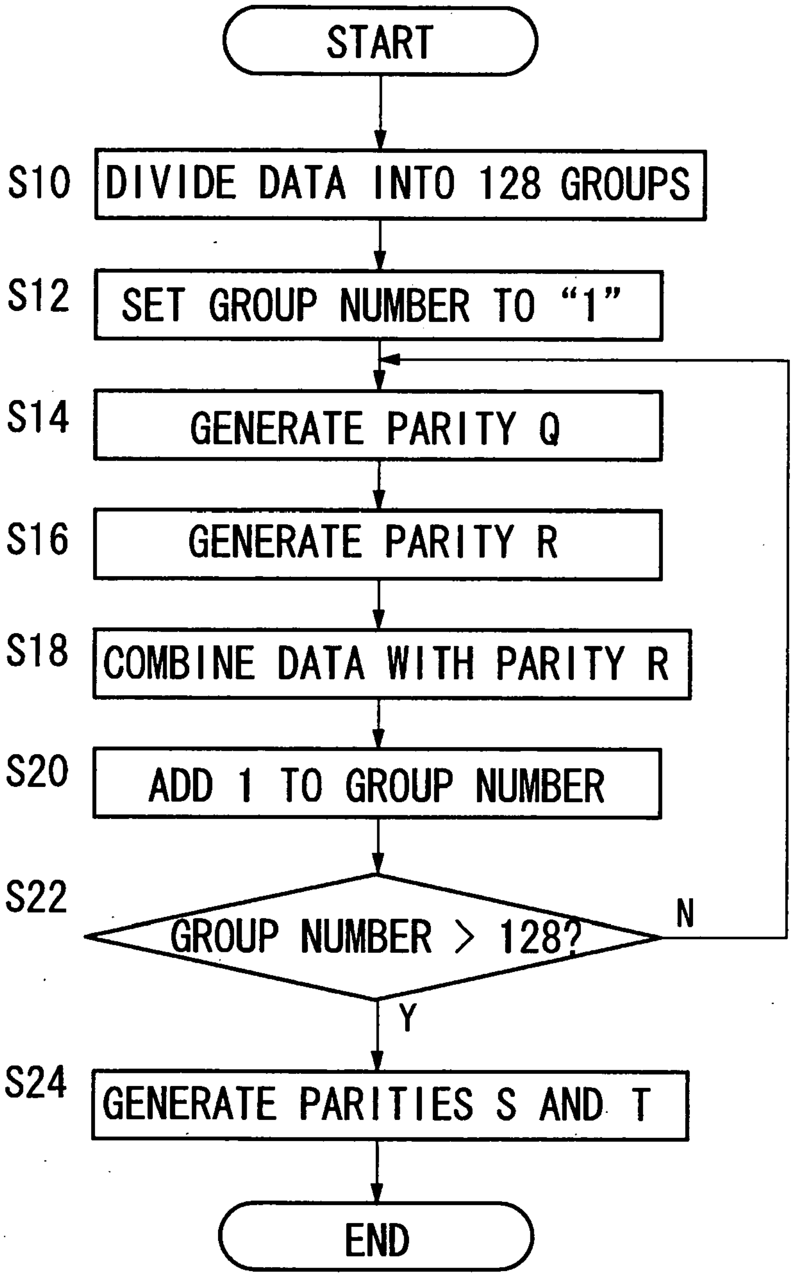
START
S10
DIVIDE DATA INTO 128 GROUPS
S12
SET GROUP NUMBER TO "1"
S14
GENERATE PARITY Q
S16
GENERATE PARITY R
S18
COMBINE DATA WITH PARITY R
S20
ADD 1 TO GROUP NUMBER
S22
GROUP NUMBER > 128?
N
Y
S24
GENERATE PARITIES S AND T
END

FIG.11

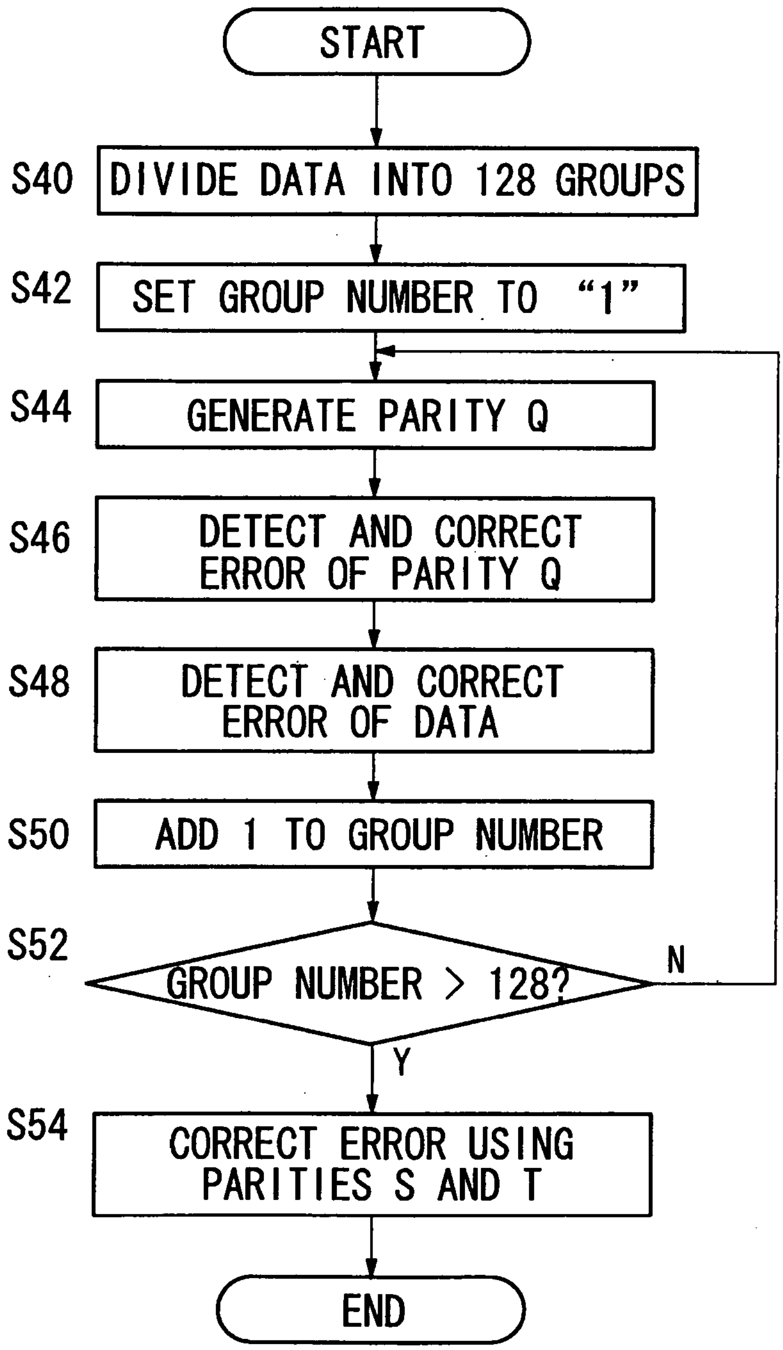
START
S40
DIVIDE DATA INTO 128 GROUPS
S42
SET GROUP NUMBER TO "1"
S44
GENERATE PARITY Q
S46
DETECT AND CORRECT ERROR OF PARITY Q
S48
DETECT AND CORRECT ERROR OF DATA
S50
ADD 1 TO GROUP NUMBER
S52
GROUP NUMBER > 128?
N
Y
S54
CORRECT ERROR USING PARITIES S AND T
END

FIG.12

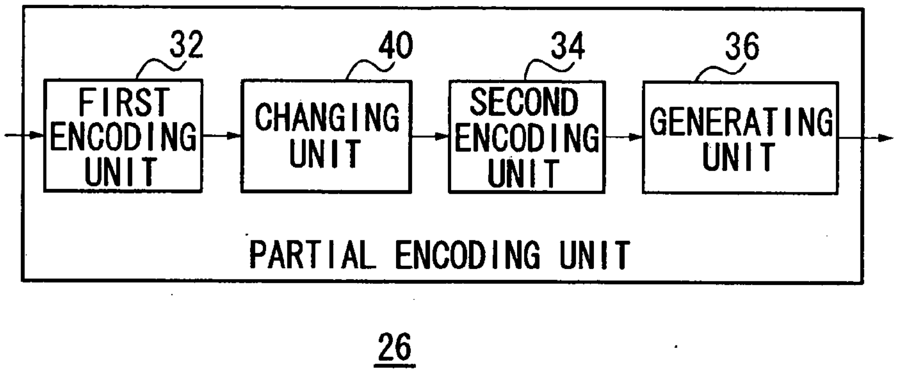
32
40
34
36
FIRST ENCODING UNIT
CHANGING UNIT
SECOND ENCODING UNIT
GENERATING UNIT
PARTIAL ENCODING UNIT
26

FIG.13

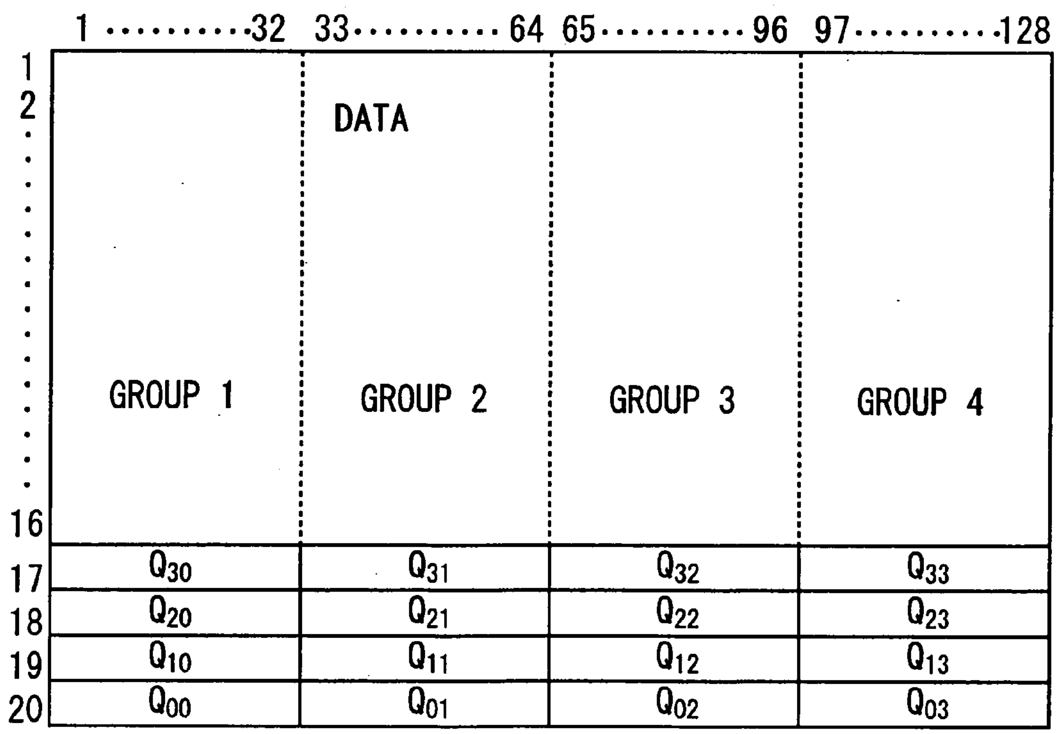
1 ··········32
33··········64
65··········96
97··········128
1
2
16
17
18
19
20
DATA
GROUP 1
GROUP 2
GROUP 3
GROUP 4
Q30
Q31
Q32
Q33
Q20
Q21
Q22
Q23
Q10
Q11
Q12
Q13
Q00
Q01
Q02
Q03

FIG.14

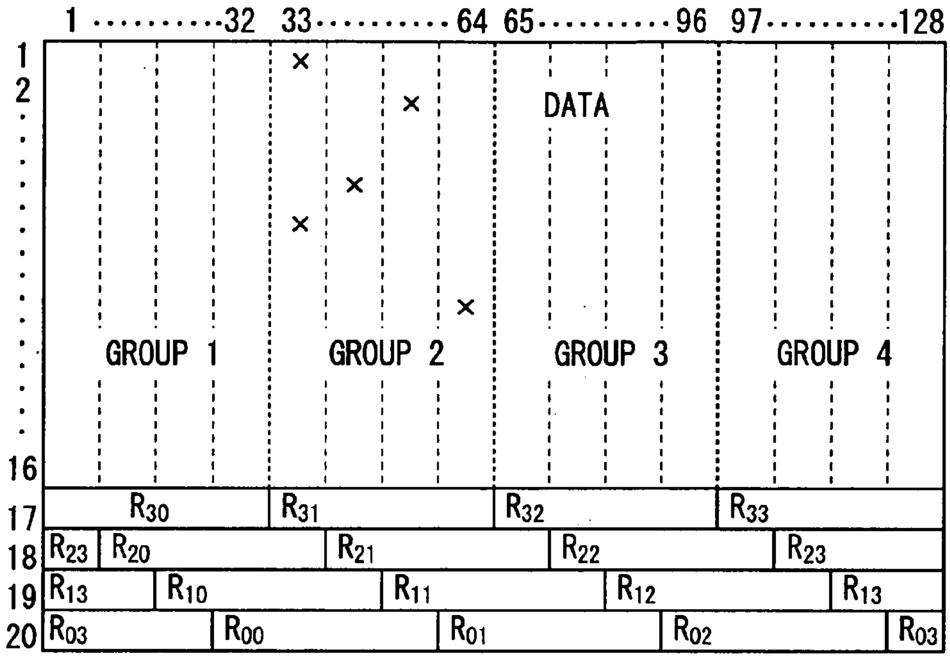
1 ··········32 33··········64 65··········96 97··········128
1
2
16
17
18
19
20
DATA
GROUP 1
GROUP 2
GROUP 3
GROUP 4
$R_{30}$ $R_{31}$ $R_{32}$ $R_{33}$
$R_{23}$ $R_{20}$ $R_{21}$ $R_{22}$ $R_{23}$
$R_{13}$ $R_{10}$ $R_{11}$ $R_{12}$ $R_{13}$
$R_{03}$ $R_{00}$ $R_{01}$ $R_{02}$ $R_{03}$

FIG.15

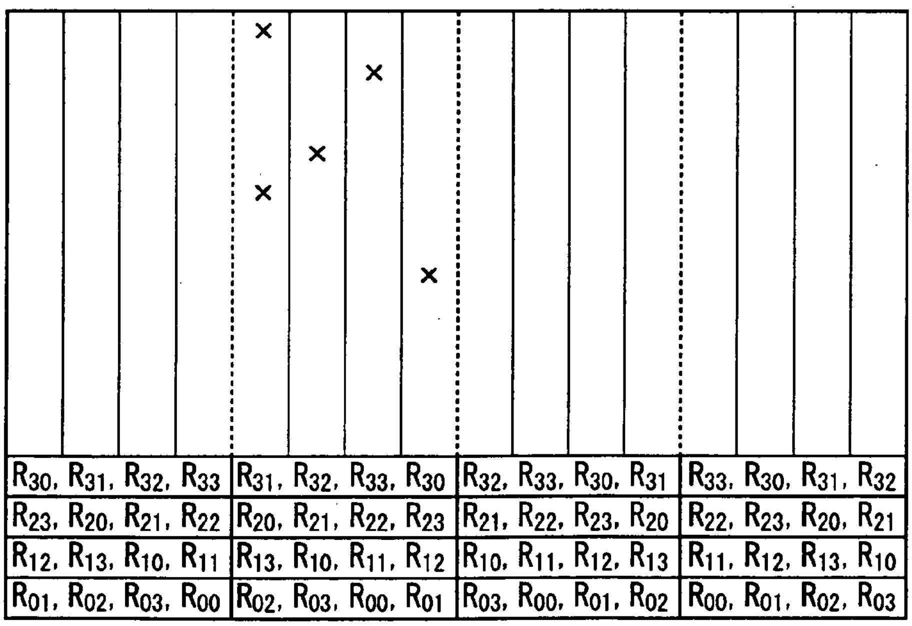
$R_{30}$, $R_{31}$, $R_{32}$, $R_{33}$
$R_{31}$, $R_{32}$, $R_{33}$, $R_{30}$
$R_{32}$, $R_{33}$, $R_{30}$, $R_{31}$
$R_{33}$, $R_{30}$, $R_{31}$, $R_{32}$
$R_{23}$, $R_{20}$, $R_{21}$, $R_{22}$
$R_{20}$, $R_{21}$, $R_{22}$, $R_{23}$
$R_{21}$, $R_{22}$, $R_{23}$, $R_{20}$
$R_{22}$, $R_{23}$, $R_{20}$, $R_{21}$
$R_{12}$, $R_{13}$, $R_{10}$, $R_{11}$
$R_{13}$, $R_{10}$, $R_{11}$, $R_{12}$
$R_{10}$, $R_{11}$, $R_{12}$, $R_{13}$
$R_{11}$, $R_{12}$, $R_{13}$, $R_{10}$
$R_{01}$, $R_{02}$, $R_{03}$, $R_{00}$
$R_{02}$, $R_{03}$, $R_{00}$, $R_{01}$
$R_{03}$, $R_{00}$, $R_{01}$, $R_{02}$
$R_{00}$, $R_{01}$, $R_{02}$, $R_{03}$

FIG.16

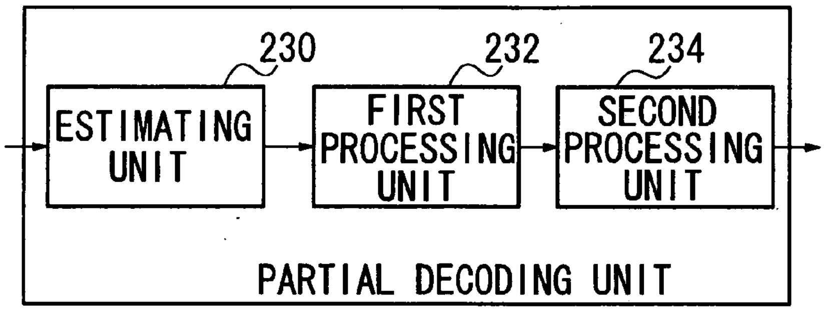
230
232
234
ESTIMATING UNIT
FIRST PROCESSING UNIT
SECOND PROCESSING UNIT
PARTIAL DECODING UNIT

224

FIG.17

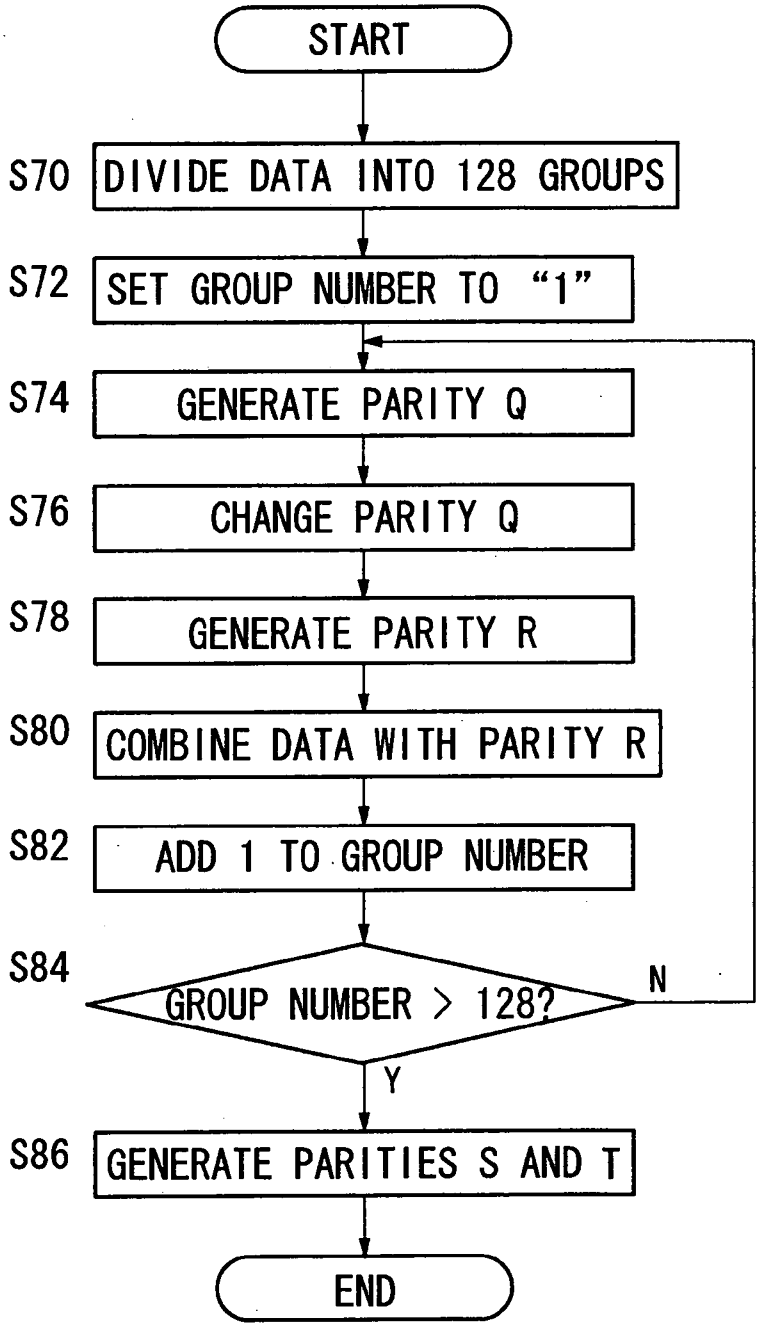
START
S70
DIVIDE DATA INTO 128 GROUPS
S72
SET GROUP NUMBER TO "1"
S74
GENERATE PARITY Q
S76
CHANGE PARITY Q
S78
GENERATE PARITY R
S80
COMBINE DATA WITH PARITY R
S82
ADD 1 TO GROUP NUMBER
S84
GROUP NUMBER > 128?
N
Y
S86
GENERATE PARITIES S AND T
END

Europäisches Patentamt
European Patent Office
Office européen des brevets

# EUROPEAN SEARCH REPORT

Application Number
EP 09 00 8577

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 5 371 751 A (MORIYAMA YOSHIAKI [JP]) 6 December 1994 (1994-12-06)<br>* column 3, line 15 - column 5, line 38 *<br>* figure 1 * | 1,8<br><br>2-7,9-11 | INV.<br>H03M13/29 |
| A | MARKUS BREITBACH; MARTIN BOSSERT; VIKTOR ZYABLOV; VLADIMIR SIDORENKO: "Array Codes Correcting a Two-Dimensional Cluster of Errors"<br>IEEE TRANSACTIONS ON INFORMATION THEORY, IEEE, US,<br>vol. 44, no. 5,<br>1 September 1998 (1998-09-01), XP011027139<br>ISSN: 0018-9448<br>* abstract *<br>* page 2025, right-hand column - page 2028, left-hand column *<br>* figures 1,2 * | 1-11 | |
| A | US 2002/038442 A1 (CYPHER ROBERT [US]) 28 March 2002 (2002-03-28)<br>* paragraph [0032] - paragraph [0047] *<br>* figures 3-6 * | 1-11 | TECHNICAL FIELDS SEARCHED (IPC)<br>H03M |
| A | US 5 838 267 A (WANG YI-PIN ERIC [US]; CHENNAKESHU SANDEEP [US]; DENT PAUL W [US]; BAL) 17 November 1998 (1998-11-17)<br>* column 4, line 33 - column 6, line 10 *<br>* figures 2,3,4 * | 1-11 | |
| A | US 2007/044005 A1 (AMRAM NOAM [IL]; ENTIN LEONID [IL]) 22 February 2007 (2007-02-22)<br>* paragraph [0043] - paragraph [0047] *<br>* figure 1 *<br>-/-- | 1-11 | |

The present search report has been drawn up for all claims

3

| Place of search | Date of completion of the search | Examiner |
|---|---|---|
| Munich | 9 October 2009 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 09 00 8577

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | RON M ROTH; GADIEL SEROUSSI: "Reduced-Redundancy Product Codes for Burst Error Correction" IEEE TRANSACTIONS ON INFORMATION THEORY, IEEE, US, vol. 44, no. 4, 1 July 1998 (1998-07-01), XP011027116 ISSN: 0018-9448 * page 1397, right-hand column - page 1401, left-hand column * * figure 3 * ----- | 1-11 | |
| | | | TECHNICAL FIELDS SEARCHED (IPC) |

The present search report has been drawn up for all claims

| Place of search | Date of completion of the search | Examiner |
|---|---|---|
| Munich | 9 October 2009 | Burkert, Frank |

3

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 09 00 8577

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2009

| Patent document cited in search report | Publication date | Patent family member(s) | Publication date |
|---|---|---|---|
| US 5371751 A | 06-12-1994 | JP 2066336 C | 24-06-1996 |
| | | JP 4120631 A | 21-04-1992 |
| | | JP 7099503 B | 25-10-1995 |
| US 2002038442 A1 | 28-03-2002 | DE 69910320 D1 | 18-09-2003 |
| | | DE 69910320 T2 | 17-06-2004 |
| | | EP 0989492 A2 | 29-03-2000 |
| | | JP 2000112830 A | 21-04-2000 |
| | | US 6304992 B1 | 16-10-2001 |
| US 5838267 A | 17-11-1998 | AU 724590 B2 | 28-09-2000 |
| | | AU 4655997 A | 05-05-1998 |
| | | BR 9711877 A | 24-08-1999 |
| | | CA 2267211 A1 | 16-04-1998 |
| | | CN 1449152 A | 15-10-2003 |
| | | CN 1240067 A | 29-12-1999 |
| | | DE 69720544 D1 | 08-05-2003 |
| | | DE 69720544 T2 | 15-01-2004 |
| | | DE 69721028 D1 | 22-05-2003 |
| | | DE 69721028 T2 | 27-11-2003 |
| | | EP 0931383 A2 | 28-07-1999 |
| | | JP 3860218 B2 | 20-12-2006 |
| | | JP 2001502861 T | 27-02-2001 |
| | | KR 20000048678 A | 25-07-2000 |
| | | WO 9816016 A2 | 16-04-1998 |
| US 2007044005 A1 | 22-02-2007 | EP 1671425 A2 | 21-06-2006 |
| | | WO 2005025106 A2 | 17-03-2005 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004282600 A